(19) Europäisches Patentamt
European Patent Office
Office européen des brevets

(11) Veröffentlichungsnummer: **0 255 802 B1**

# (12) EUROPÄISCHE PATENTSCHRIFT

(45) Veröffentlichungstag der Patentschrift: **08.04.92**

(51) Int. Cl.⁵: **C08F 222/40**

(21) Anmeldenummer: **87810437.1**

(22) Anmeldetag: **31.07.87**

## (54) Copolymere aus N-Hydroxyphenylmaleinimid(derivaten) und Allylverbindungen.

(30) Priorität: **06.08.86 CH 3156/86**

(43) Veröffentlichungstag der Anmeldung:
**10.02.88 Patentblatt 88/06**

(45) Bekanntmachung des Hinweises auf die Patenterteilung:
**08.04.92 Patentblatt 92/15**

(84) Benannte Vertragsstaaten:
**CH DE FR GB IT LI NL SE**

(56) Entgegenhaltungen:
**US-A- 4 205 151**
**US-A- 4 388 451**

**CHEMICAL ABSTRACTS, Band 98, Nr. 22, Mai 1983, Seite 30, Ref.Nr. 180366d, Columbus Ohio, US**

(73) Patentinhaber: **CIBA-GEIGY AG**
**Klybeckstrasse 141**
**CH-4002 Basel(CH)**

(72) Erfinder: **Roth, Martin, Dr.**
**Oberdorf**
**CH-1711 Giffers(CH)**
Erfinder: **Flury, Peter, Dr.**
**Muldenweg**
**CH-4249 Himmelried(CH)**
Erfinder: **Eldin, Sameer H., Dr.**
**Route de Schiffenen 10**
**CH-1700 Fribourg(CH)**

**EP 0 255 802 B1**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die vorliegende Erfindung betrifft neue Copolymere aus N-Hydroxyphenylmaleinimid(derivaten) und Allylverbindungen, ein Verfahren zur Herstellung dieser Polymeren, die Verwendung dieser Verbindungen als Bindemittel für Photoresists oder Epoxidhärter sowie die Verwendungen der epoxidgruppenhaltigen Vertreter dieser Verbindungen als selbstvernetzende Harze.

Homopolymere von 4-substituierten Phenylmaleinimiden sind bekannt, beispielsweise aus Kobunshi Kagaku 26, 393-400 (1969) (Chem. Abstr. 71, 61815 g). Homopolymere von N-(4-Hydroxyphenyl)-maleinimiden sind aus der BE-PS 613,801 bekannt. Auch über Copolymere aus N-Hydroxyphenylmaleinimid und (Meth)acrylsäurederivaten oder anderen Vinylmonomeren wurde bereits berichtet, beispielsweise in Kobunshi Kagaku 29, 643-7 (1972) bzw. 26, 593-601 (1969) (Chem. Abstr. 78, 16624c bzw. 72, 21964u oder von S.R. Turner et al. in Photopolymer Conference, Ellenville USA, 22.-30. Oktober 1985.

Es ist bekannt, dass sich durch den Einbau von N-Hydroxyphenylmaleinimiden die Glasübergangstemperatur von Vinylcopolymeren steigern lässt. Solche Harze lassen sich potentiell als Bindemittel in positiven Photolacken einsetzen (vergl. Turner et al.).

Allerdings lassen sich die Bindemittel, die üblicherweise in Positiv-Resists verwendet werden, in der Regel nicht in Negativ-Resists einsetzen. Insbesondere Polyphenole, beispielsweise Novolake auf Phenol- und Formaldehydbasis, wurden bislang zwar in Positiv-Resists nicht aber in Negativ-Resists eingesetzt. Ueberraschenderweise lassen sich die erfindungsgemässen N-Hydroxyphenylmaleinimid-Copolymeren sowohl in Positiv- als auch in Negativ-Resists verwenden. Auf diese Weise lassen sich wässrig-alkalisch entwickelbare Negativsysteme mit hoher Temperatur- und Formstabilität herstellen.

Es wurde jetzt gefunden, dass man die Flexibilität von N-Hydroxyphenylmaleinimid-Polymeren verbessern kann, indem man Allylmonomere in das Polymergerüst einbaut. Ausserdem wurde eine Untergruppe solcher Polymerer gefunden, die gleichzeitig eine phenolische Hydroxylgruppe und einem Glycidylrest in einem Molekül enthalten und die als selbstvernetzende Epoxidharze eingesetzt werden können.

Ferner ist bekannt, das Allylverbindungen nur relativ schlecht polymerisiert werden können (vergl. Yocum/Nyquist, 'Functional Monomers', Vol. 1, 384 ff, Marcel Dekker Inc., New York, 1975). Es war daher überraschend zu finden, dass die Polymerisation von N-Hydroxyphenylmaleinimiden mit Allylverbindungen rasch und unter milden Bedingungen abläuft und dass sich relativ hohe Molekulargewichte erreichen lassen.

Die vorliegende Erfindung betrifft Copolymere enthaltend 30-100 Mol%, bezogen auf das Gesamtpolymere, an Struktureinheiten der Formeln I und II, wobei der Anteil der Struktureinheiten der Formel I, bezogen auf den gesamten Anteil von I und II, 5 bis 95 Mol% ausmacht

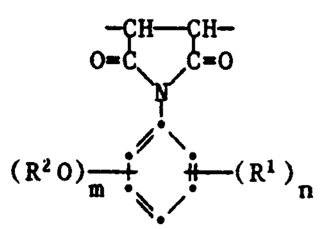 (I), 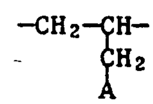 (II),

worin $R^1$ $C_1$-$C_4$Alkyl, $C_1$-$C_4$Alkoxy oder Halogen ist,
$R^2$ Wasserstoff oder -$COR^3$ bedeutet und $R^3$ $C_1$-$C_{20}$Alkyl ist,
m 1, 2 oder 3 darstellt, n 0, 1, 2, 3 oder 4 ist und die Summe von m und n höchstens 5 bedeutet, A ausgewählt wird aus der Gruppe der Reste bestehend aus Halogen, Cyano oder Struktureinheiten der Formeln III bis VIII

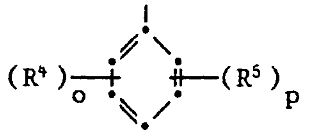 (III), 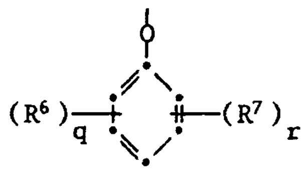 (IV),

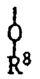 (V), 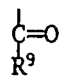 (VI), 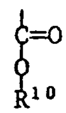 (VII), 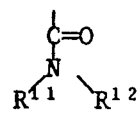 (VIII),

worin $R^4$ und $R^6$ unabhängig voneinander Hydroxy,

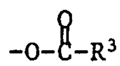

oder Glycidylgruppen der Formel IXa oder IXb darstellen

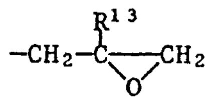 (IXa), 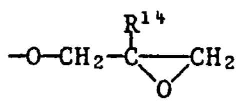 (IXb),

$R^5$ und $R^7$ unabhängig voneinander $C_1$-$C_4$Alkyl, $C_1$-$C_4$Alkoxy oder Halogen sind,
o und q unabhängig voneinander 0, 1, 2 oder 3 sind,
p und r unabhängig voneinander 0, 1, 2, 3, 4 oder 5 bedeuten,
wobei die Summen o + p und q + r höchstens 5 betragen dürfen,
$R^8$ Wasserstoff, $C_1$-$C_{20}$Alkyl, ein Glycidylrest der Formel IXa oder ein Rest der Formel VI ist,
$R^9$ Wasserstoff, $C_1$-$C_{20}$Alkyl, Cycloalkyl mit 5-7 Ring C-Atomen, Phenyl, Naphthyl oder Benzyl darstellt,
$R^{10}$ Wasserstoff, $C_1$-$C_{20}$Alkyl oder ein Glycidylrest der Formel IXa ist und die Gruppen $R^{11}$ und $R^{12}$ unabhängig voneinander Wasserstoff, $C_1$-$C_{20}$Alkyl, Cycloalkyl mit 5-7 Ring C-Atomen, gegebenenfalls substituiertes Aryl oder ein Glycidylrest der Formel IXa sind oder zusammen mit dem gemeinsamen Stickstoffatom einen fünf- oder sechsgliedrigen nichtaromatischen heterocyclischen Ring bilden und
$R^{13}$ und $R^{14}$ unabhängig voneinander Wasserstoff oder Methyl sind,
wobei die Reste $R^1$ bis $R^{14}$ und A eines Polymermoleküls innerhalb der gegebenen Definitionen unterschiedlich sein können;
und 70-0 mol%, bezogen auf das Gesamtpolymere, au Struktureinheiten, die sich von radikalisch polymerisierbaren Vinylverbindungen ableiten.

Bedeuten $R^1$, $R^5$ oder $R^7$ $C_1$-$C_4$Alkyl, so handelt es sich dabei um geradkettige oder verzweigte, bevorzugt um geradkettige, Alkylreste. Beispiele für solche Gruppen sind Methyl, Ethyl, n-Propyl, Isopropyl, n-Butyl oder sek.Butyl. Bevorzugt wird Methyl.

Als $C_1$-$C_4$Alkoxy besitzt der Alkylteil von $R^1$, $R^5$ oder $R^7$ die oben beispielhaft erwähnten Bedeutungen. Bevorzugt wird Methoxy.

Als Halogen sind $R^1$, $R^5$ oder $R^7$ Fluor, Chlor, Brom oder Iod. Bevorzugt wird Chlor oder Brom, insbesondere Brom.

Sind irgendwelche Reste $C_1$-$C_{20}$Alkyl, so handelt es sich dabei bevorzugt um geradkettige Gruppen. Es können aber auch verzweigte Alkylgruppen sein.

Beispiele für $C_1$-$C_{20}$Alkylreste sind Methyl, Ethyl, n-Propyl, Isopropyl, n-Butyl, sek.Butyl, tert.Butyl, n-Pentyl, Isoamyl, n-Hexyl, n-Heptyl, n-Octyl, 2-Ethylhexyl, n-Nonyl, n-Decyl, n-Undecyl, n-Dodecyl, n-Tetradecyl, n-Hexadecyl, n-Octadecyl oder n-Eicosyl. Bevorzugt werden $C_1$-$C_8$Alkylreste dieses Typs, insbesondere die geradkettigen und ganz besonders Methyl oder Ethyl.

A als Halogen ist Fluor, Chlor, Brom oder Iod. Bevorzugt wird Chlor oder Brom, insbesondere Chlor.

Bei $R^9$, $R^{11}$ und $R^{12}$ als Cycloalkyl mit 5-7 Ring C-Atomen handelt es sich in der Regel um Cyclopentyl, Cyclohexyl oder Cycloheptyl, insbesondere jedoch um Cyclohexyl. Diese Reste sind gegebenenfalls alkylsubstituiert.

Als gegebenenfalls substituiertes Aryl sind $R^{11}$ oder $R^{12}$ beispielsweise Phenyl oder Naphthyl. Als Substituenten kommen beispielsweise Alkylgruppen, insbesondere Methyl, Alkoxygruppen, insbesondere Methoxy, Halogenatome, insbesondere Chlor oder Brom, oder Cyanogruppen in Frage.

Spezifische Beispiele für substituierte Arylreste sind o-, m- oder p-Tolyl, Xylyl oder Chlorphenyl. Bevorzugt wird Phenyl.

Als gegebenenfalls substituiertes Aralkyl sind $R^{11}$ oder $R^{12}$ beispielsweise Benzyl, $\alpha$-Methylbenzyl oder $\alpha,\alpha$-Dimethylbenzyl. Auch hier kommen als Substituenten die oben für Aryl beispielhaft erwähnten Reste in Frage.

Spezifische Beispiele für subsituierte Aralkylreste sind 4-Methylbenzyl oder 4-Methoxybenzyl. Bevorzugt wird Benzyl.

Bilden $R^{11}$ und $R^{12}$ zusammen mit dem gemeinsamen Stickstoffatom einen fünf- oder sechsgliedrigen nichtaromatischen heterocyclischen Ring, so handelt es sich dabei beispielsweise um Piperidyl, Pyrrolidinyl oder Morpholinyl.

Bevorzugt werden Copolymere, wie oben definiert, worin der Anteil der Struktureinheiten I und II 50-100 Mol%, bezogen auf das Gesamtpolymere, ausmacht.

Ganz besonders bevorzugt werden Copolymere bestehend im wesentlichen aus Strukturelementen der Formeln I und II. Unter dem Begriff 'im wesentlichen' ist ein solcher Gehalt an Strukturelementen der Formeln I und II zu verstehen, der verglichen mit einem Polymeren bestehend aus ausschliesslich den entsprechenden Struktureinheiten I und II zu keinem merklichen Unterschied in den thermischen, elektrischen und mechanischen Eigenschaften des Polymeren führt.

Insbesondere bevorzugt werden Copolymere bestehend ausschliesslich aus Strukturelementen der Formeln I und II.

Ebenfalls bevorzugt werden Copolymere, wie oben definiert, worin der Anteil der Reste der Formel I, bezogen auf den Anteil von I und II, 10-80 Mol%, besonders bevorzugt 30-75 Mol%, ausmacht.

Weiterhin bevorzugt werden Copolymere enthaltend Struktureinheiten der Formeln I und II, worin $R^2$ Wasserstoff bedeutet. Hierbei handelt es sich um Copolymere mit N-Hydroxyphenylmaleinimidresten als Monomereinheit.

Auch werden Copolymere enthaltend die Struktureinheiten der Formeln I und II bevorzugt, worin $R^2$ Wasserstoff bedeutet und A ausgewählt wird aus der Gruppe der Reste der Formeln III, IV, V, VII und VIII, $R^4$ und $R^6$ Glycidylgruppen der Formeln IXa oder IXb darstellen, $R^8$, $R^{10}$ und mindestens einer der Reste $R^{11}$ oder $R^{12}$ eine Glycidylgruppe der Formel IXa ist und o und q unabhängig voneinander 1, 2 oder 3 sind.

Ganz besonders bevorzugt werden Copolymere enthaltend die Struktureinheiten der Formeln I und II, vorzugsweise solche mit m = 1 und n = 0, worin $R^2$ Wasserstoff bedeutet, A ein Rest der Formel V ist und $R^8$ eine Gruppe der Formel IXa bedeutet. Ebenfalls besonders bevorzugt werden Copolymere enthaltend Struktureinheiten der Formeln I und II, vorzugsweise solche mit m = 1 und n = 0, worin $R^2$ Wasserstoff bedeutet, A eine Gruppe der Formeln III oder IV ist, $R^4$ und $R^6$ Glycidylgruppen der Formel IXb sind, o und q 1 oder 2, insbesondere 1, bedeuten und p und r 0 sind.

Der Index m ist vorzugsweise 1 oder 2, insbesondere 1.

Der Index n bedeutet bevorzugt 0, 1 oder 2, insbesondere jedoch 0 oder 1, ganz besonders 0.
Die Indizes o und q sind vorzugsweise 0 oder 1, besonders bevorzugt 0. Bei Comonomeren mit Glycidylresten sind sie vorzugsweise 1. Die Indizes q und r sind bevorzugt 0 oder 1, insbesondere 0.

Bevorzugt werden weiterhin Copolymere mit den Struktureinheiten der Formeln I und II, worin $R^2$ Wasserstoff bedeutet, m 1 ist, n 0, 1 oder 2 bedeutet, A ausgewählt wird aus der Gruppe bestehend aus den Resten der Formeln III, IV oder V und $R^8$ $C_1$-$C_4$Alkyl oder ein Rest der Formel VI ist, worin $R^9$ $C_1$-$C_4$Alkyl bedeutet.

Die erfindungsgemässen Copolymeren lassen sich überraschenderweise unter milden Bedingungen in hoher Ausbeute und mit relativ hohen Molekulargewichten ($M_n$: 500-100000) herstellen.

Gegenstand der Erfindung ist daher auch ein Verfahren zur Herstellung dieser Copolymeren dadurch gekennzeichnet, dass man

a) 30-100 mol% Verbindungen der Formel Ia und IIa

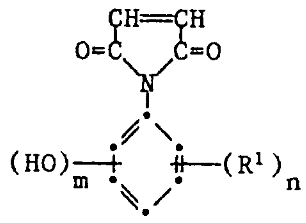 (Ia), 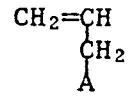 (IIa),

worin $R^1$, A, m und n die weiter oben definierte Bedeutung besitzen, gegebenenfalls in Anwesenheit von 70-0 mol% weiterer radikalisch polymerisierbarer Vinylverbindungen radikalisch polymerisiert und das Produkt gegebenenfalls mit einem zur Einführung des Restes $R^3$-CO- befähigten Reagenz weiter umsetzt, bevorzugt jedoch keine weitere Umsetzung mit besagtem Reagenz durchführt, oder dass man

b) 30-100 mol% Verbindungen der Formel Ib und IIa

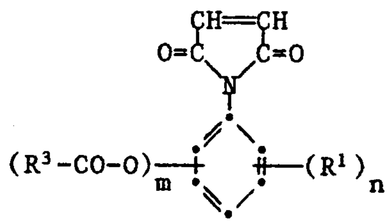 (Ib), 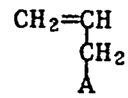 (IIa),

worin $R^1$, $R^3$, A, m und n die schon weiter oben definierte Bedeutung besitzen, gegebenenfalls in Anwesentheit von 70-0 mol% weiterer radikalisch polymerisierbarer Vinylverbindungen radikalisch polymerisiert und das Produkt gegebenenfalls durch (teilweise) Hydrolyse der $R^3$-CO- Gruppe in ein anderes Copolymeres gemäss der weiter oben gegebenen Definition überführt. In der Variante b) des erfindungsgemässen Verfahrens wird bevorzugt die vollständige Hydrolyse des Restes $R^3$-CO- durchgeführt.

Eine weitere Bevorzugung der Verfahrensvariante b) betrifft den Einsatz glycidylgruppenhaltiger Allylverbindungen IIa, besonders bevorzugt den Einsatz von Allylverbindungen, worin A ein Rest der Formel V ist und $R^8$ eine Gruppe der Formel IXa bedeutet, oder worin A ein Rest der Formel III oder IV ist, $R^4$ und $R^6$ Glycidylgruppen der Formel IXb sind, o und q 1 oder 2 bedeuten und p und r 0 sind. Die Verbindungen der Formeln Ia und Ib sind an sich bekannt oder können nach Standardreaktionen hergestellt werden. Diese Verbindungen und ihre Herstellung sind beispielsweise in der US-PS 4,289,699 beschrieben.

Die Allylverbindungen der Formeln IIa sind ebenfalls bekannt und teilweise im Handel erhältlich.

Neben den Monomeren der Formeln Ia und IIa bzw. Ib und IIa können gegebenenfalls noch bis zu 70 mol% weitere radikalisch polymerisierbare Vinylverbindungen anwesend sein.

Beispiele für Monomere dieses Typs sind

a) Styroltypen, wie beispielsweise Styrol, $\alpha$-Methylstyrol, p-Methylstyrol oder p-Hydroxyphenylstyrol;

b) $\alpha,\beta$-ungesättigte Säuren, deren Ester oder Amide, wie beispielsweise Acrylsäure, Acrylsäuremethylester, Acrylsäureamid, die entsprechenden Methacrylverbindungen, Maleinsäure oder Maleinsäuremethylester;

c) Nitrile von $\alpha,\beta$-ungesättigten Säuren, wie beispielsweise Acrylnitril oder Methacrylnitril;

d) halogenhaltige Vinylverbindungen, wie beispielsweise Vinylchlorid, Vinylfluorid, Vinylidenchlorid oder Vinylidenfluorid;

e) Vinylester, wie beispielsweise Vinylacetat oder

f) Vinylether, wie beispielsweise Methylvinylether oder Butylvinylether.

Es kann sich bei diesen Monomeren aber auch um Olefine handeln, beispielsweise um Ethylen oder Propylen.

Man kann auch Mischungen dieser Monomeren einsetzen.

Die Herstellung der Copolymeren geschiet durch radikalische Polymerisation der entsprechenden Monomermischung mittels Hitze oder aktinischer Strahlung. Das Allylmonomere der Formel IIa wird dabei bevorzugt im Ueberschuss eingesetzt, da das N-Hydroxyphenylmaleinimid(derivat) der Formel Ia oder Ib die Tendenz besitzt, vorzugsweise mit sich selbst zu polymerisieren. Durch die Wahl eines Ueberschusses an Allylverbindung lässt sich das Comonomerenverhältnis beliebig steuern. In der Regel muss nach der Reaktion überschüssiges Allylmonomeres vom Copolymer abgetrennt werden. Dies erfolgt in an sich bekannter Weise, z.B. durch Fällen des Copolymers in einem Nichtlösungsmittel. Die Polymerisation wird in

der Regel durch einen der üblichen Initiatoren der radikalischen Polymerisation eingeleitet.

Dazu zählen thermische Initiatoren, wie Azoverbindungen, beispielsweise Azoisobutyronitril (AIBN), oder Peroxide, beispielsweise - Benzoylperoxid, oder Redoxinitiatorsysteme, wie eine Mischung von Eisen(III)-acetyl-acetonat, Benzoin und Benzoylperoxid, oder photochemische Radikalbildner, wie Benzoin oder Benzilmethylketal.

Die Copolymerisation kann in Lösung ausgeführt werden. Die Reaktionstemperatur bewegt sich im allgemeinen im Bereich von 10 bis 200 ° C, vorzugsweise zwischen 40 und 150 ° C, besonders bevorzugt zwischen 40 und 100 ° C.

Gegebenenfalls anwesende Lösungsmittel müssen unter Reaktionsbedingungen inert sein. Als Lösungsmittel kommen u.a. aromatische Kohlenwasserstoffe, chlorierte Kohlenwasserstoffe und Ketone in Betracht. Beispiele dafür sind Benzol, Toluol, Xylol, Ethylbenzol, Isopropylbenzol, Ethylenchlorid, Propylenchlorid, Methylenchlorid, Chloroform, Methylethylketon, Aceton oder Cyclohexanon.

Die Reaktionbedingungen insbesondere die Wahl des Initiators und des Lösungsmittels, sind allgemein bekannt und in der Literatur ausführlich beschrieben (beispielweise in Houben-Weyl, Methoden der organischen Chemie, Bd. 14/1, S. 24-110; G. Thieme Verlag 1961).

Als Polymerisationsverfahren finden die üblichen Verfahren Anwendung, wie beispielsweise Polymerisation in der Masse oder in Lösungsmitteln, Emulsions-, Suspensions- oder Fällungspolymerisation.

Unter den gewählten Reaktionsbedingungen entstehen sogenannte statistische Copolymere, d.h. Polymere, in denen die Reihenfolge der einzelnen Monomereinheiten zufällig ist. Das Molekulargewicht der Produkte ($\overline{M}_n$; gemessen durch Gel-Permeationschromatographie) variiert in der Regel zwischen etwa 500 und 100000, insbesondere zwischen 1000 und 50000.

Die erfindungsgemässen Copolymeren sind feste Produkte, die in zahlreichen organischen Lösungsmitteln löslich sind, beispielsweise in Ketonen oder Estern. Bei einem genügend grossen Anteil an Struktureinheiten der Formel I mit phenolischen Hydroxylgruppen lassen sich die Copolymeren sogar in Wasser, bevorzugt in wässrig alkalischen Medien, lösen.

Unter einem zur Einführung des Restes $R^3$-CO- befähigten Reagenz, mit dem das Produkt der Polymerisation der Monomeren Ia und IIa gegebenenfalls weiter umgesetzt wird, versteht man ganz allgemein ein Acylierungsmittel. Dabei handelt es sich insbesondere um Carbonsäuren oder deren aktivierte Derivate, beispielsweise die entsprechenden Säurechloride, insbesondere Acetylchlorid.

An die Polymerisation der Monomeren Ib und IIa schliesst sich gegebenenfalls eine Hydrolysestufe an. Dabei wird die Acylgruppe des N-Phenylmaleinimidylrestes abgespalten. Die Spaltung erfolgt nach an sich üblichen Methoden, beispielsweise durch Hydrolyse im sauren oder basischen Medium. Eine solche Reaktionsfolge wird von S.R. Turner et al. in 'Photopolymer Conference, Ellenville USA (28.-30. October 1985), S. 35-47' beschrieben.

Die erfindungsgemässen Copolymeren finden beispielsweise Verwendung als Bindemittel für Positiv- und Negativ-Photoresistsysteme. Bevorzugt setzt man für diesen Zweck die Derivate mit N-(Hydroxyphenyl)-maleinimideinheiten ein. Diese Verbindungen lassen sich aufgrund ihres Gehaltes an phenolischen Hydroxylgruppen in wässrig-alkalischen Lösungen entwickeln, und ihre Verwendung als Bindemittel für Photoresists ist ebenfalls Gegenstand dieser Erfindung.

Die Copolymeren gestatten die Herstellung thermisch beständiger Resistbilder mit guter Auflösung, da sie im allgemeinen relativ hohe Glasübergangstemperaturen ($T_g$) kombiniert mit guten mechanischen Eigenschaften aufweisen.

Die Anwendung der entsprechenden N-(Hydroxyphenyl)maleimid-/Vinylcopolymeren als Bindemittel in Positiv-Resists wird im oben zitierten Artikel von S.R. Turner et al. beschrieben.

Besonders eignen sich die erfindungsgemässen Copolymeren als Bindemittel für Negativ-Resistsysteme auf Basis von Epoxidharzen und kationischen Photoinitiatoren.

Ein weiteres Anwendungsgebiet der N-(Hydroxyphenyl)maleimid-Copolymeren der Erfindung betrifft ihren Einsatz als Härter für Epoxidharze.

Die Erfindung betrifft auch die Verwendung von N-(Hydroxyphenyl)maleinimid-Copolymeren mit glycidylsubstituierten Allyleinheiten der Formel II als selbstvernetzende Epoxidharze. Die Verbindungen weisen in ein und demselben Molekül sowohl eine Epoxidgruppe als auch eine Härterfunktion (Phenol) auf.

Sie lassen sich daher allein oder auch in Kombination mit üblichen Härtern unter Erwärmen vernetzen. Insbesondere lassen sie sich ohne weitere Härter, vorzugsweise in Anwesenheit üblicher Beschleuniger thermisch härten. Die glycidylgruppenhaltigen Copolymeren der vorliegenden Erfindung lassen sich allerdings auch im Gemisch mit weiteren, üblichen thermischen Härtern und gegebenenfalls Beschleunigern härten.

Als zusätzliche Epoxidharze, die sich in Mischung mit den erfindungsgemässen Epoxidverbindungen einsetzen lassen, eignen sich die üblicherweise in der Technik der Epoxidverbindungen eingesetzten Harze.

Dazu zählen beispielsweise Polyglycidyl- und Poly-($\beta$-methylglycidyl)-ester, Polyglycidyl- und Poly-($\beta$-methylglycidyl)-ether, Poly-(N-glycidyl)-verbindungen, Poly-(S-glycidyl)-verbindungen oder cycloaliphatische Epoxidharze.

Beispiele für die einzelnen Verbindungen dieses Typs sind in der EP-A 160,621 gegeben.

Insbesondere setzt man zusammen mit den erfindungsgemässen Epoxidharzen Polyglycidylether von Bisphenolen, wie beispielsweise von 2,2-Bis-(4-hydroxyphenyl)-propan oder Bis-(4-hydroxyphenyl)-methan, von Novolaken oder von aliphatischen Diolen ein.

Als Epoxidhärtungsmittel kommen saure, basische oder katalytische Härter in Frage. Dazu zählen beispielsweise Amine oder Amide, wie aliphatische, cycloaliphatische oder aromatische, primäre, sekundäre oder tertiäre Amine, beispielsweise Hexamethylendiamin, N,N-Diethylpropylendiamin,Bis-(4-aminocyclohexyl)-methan, 3,5,5-Trimethyl-3-(aminomethyl)-cyclohexylamin ('Isophorondiamin'), 2,4,6-Tris-(dimethylaminomethyl)-phenol, p-Phenylendiamin oder Bis-(4-aminophenyl)-methan; oder Polyamide, beispielsweise solche aus aliphatischen Polyaminen und di- oder trimerisierten ungesättigten Fettsäuren; oder mehrwertige Phenole, wie beispielsweise Resorcin, 2,2-Bis-(4-hydroxyphenyl)-propan oder Phenol-Formaldehydharze (Phenol-Novolake); oder Bortrifluorid und seine Komplexe mit organischen Verbindungen, wie beispielsweise $BF_3$-Ether-Komplexe oder $BF_3$-Amin-Komplexe; oder mehrbasische Carbonsäuren und deren Anhydride, wie beispielsweise Phthalsäureanhydrid, Tetrahydrophthalsäureanhydrid oder Hexahydrophthalsäureanhydrid oder die entsprechenden Säuren.

Derartige härtbare Gemische können ferner geeignete Weichmacher, wie Dibutylphthalat, Dioctylphthalat oder Trikresylphosphat, oder auch reaktive Verdünner, wie Phenyl- oder Kresylglycidylether, Butandioldiglycidylether oder Hexahydrophthalsäurediglycidylether enthalten.

Schliesslich können die härtbaren Gemische vor der Härtung in irgendeiner Phase mit Streck-, Füll- und Verstärkungsmitteln, wie beispielsweise Steinkohlenteer, Bitumen, Textilfasern, Glasfasern, Asbestfasern, Borfasern, Kohlenstoff-Fasern, mineralischen Silikaten, Glimmer, Quarzmehl, Aluminiumoxidhydrat, Bentoniten, Kaolin, Kieselsäureaerogel oder Metallpulvern, z.B. Aluminiumpulver oder Eisenpulver, ferner mit Pigmenten und Farbstoffen, wie Russ, Oxidfarben, Titandioxid versetzt werden. Man kann den härtbaren Gemischen ferner auch andere übliche Zusätze. z.B. Flammschutzmittel, wie Antimontrioxid, Thixotropiemittel, Verlaufmittel ("flow control agents"), wie Silicone, Wachse oder Stearate (welche zum Teil auch als Formtrennmittel Anwendung finden), zusetzen.

Die Herstellung der erfindungsgemässen härtbaren Mischungen kann in üblicher Weise mit Hilfe bekannter Mischaggregate (Rührer, Kneter, Walzen) erfolgen.

Die erfindungsgemässen härtbaren Epoxidharzmischungen finden ihren Einsatz vor allem auf den Gebieten des Oberflächenschutzes, der Elektrotechnik, der Laminierverfahren und im Bauwesen. Sie können in jeweils dem speziellen Anwendungszweck angepasster Formulierung, im ungefüllten oder gefüllten Zustand, als Anstrichmittel, Lacke, wie Sinterpulverlacke, als Pressmassen, Tauchharze, Giessharze, Spritzgussformulierungen, Imprägnierharze und Klebmittel, als Werkzeugharze, Laminierharze, Dichtungs- und Spachtelmassen, Bodenbelagsmassen und Bindemittel für mineralische Aggregate verwendet werden.

Die mit den erfindungsgemässen glycidylgruppenhaltigen Copolymeren hergestellten ausgehärteten Produkte zeichnen sich durch sehr gute thermische, elektrische und mechanische Eigenschaften aus.

Man kann bei der Härtung ausserdem Härtungsbeschleuniger einsetzen; solche Beschleuniger sind z.B. tertiäre Amine, deren Salze oder quaternäre Ammoniumverbindungen, z.B. Benzyldimethylamin, 2,4,6-Tris-(dimethylaminomethyl)phenol, 1-Methylimidazol, 2-Ethyl-4-methylimidazol, 4-Aminopyridin, Tripentylammoniumphenolat oder Tetramethylammoniumchlorid; oder Alkalimetallalkoholate, wie z.B. Na-Alkoholate von 2,4-Dihydroxy-3-hydroxymethylpentan. Die Härtung der erfindungsgemässen glycidylgruppenhaltigen Copolymeren wird zweckmässig im Temperaturintervall von 50 °C bis 300 °C, bevorzugt von 80-250 °C, durchgeführt.

Man kann die Härtung in bekannter Weise auch zwei- oder mehrstufig durchführen, wobei die erste Härtungsstufe bei niedriger Temperatur und die Nachhärtung bei höherer Temperatur durchgeführt wird.

Die Härtung kann gewünschtenfalls auch derart in 2 Stufen erfolgen, dass die Härtungsreaktion zunächst vorzeitig abgebrochen bzw. die erste Stufe bei wenig erhöhter Temperatur durchgeführt wird, wobei ein noch schmelzbares und/oder lösliches, härtbares Vorkondensat (sogenannte "B-Stufe") aus der Epoxi-Komponente (a) und dem gegebenenfalls anwesenden Härter oder Beschleuniger (b) erhalten wird. Ein derartiges Vorkondensat kann z.B. zur Herstellung von "Prepregs", Pressmassen oder Sinterpulvern dienen.

Der Ausdruck "Härten", wie er hier gebraucht wird, bedeutet die Umwandlung der löslichen, entweder flüssigen oder schmelzbaren Polyepoxide in feste, unlösliche und unschmelzbare, dreidimensional vernetzte Produkte bzw. Werkstoffe, und zwar in der Regel unter gleichzeitiger Formgebung zu Formkörpern, wie

Giesskörpern, Presskörpern und Schichtstoffen, zu Imprägnierungen, Beschichtungen, Lackfilmen und Verklebungen.

Die folgenden Beispiele erläutern die Erfindung näher.

## Herstellungsbeispiele

### Beispiel 1:

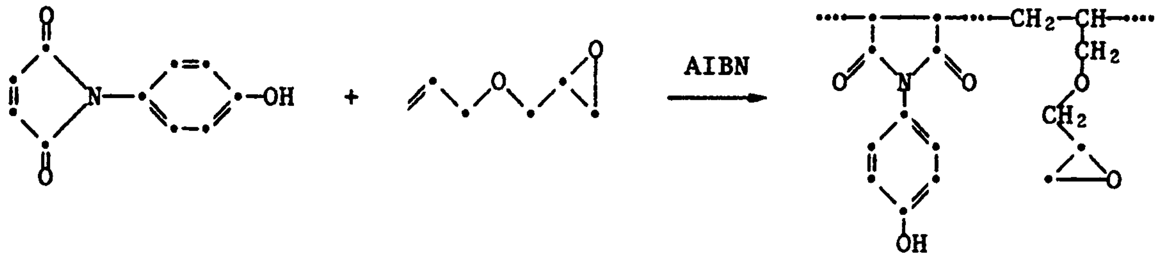


Einen 2,5 1 Sulfierkolben, versehen mit Rührer, Thermometer, Rückflusskühler sowie Stickstoffeinleitung und -ausleitung, beschickt man mit:

| | |
|---|---|
| 233,4 g ( 1,234 Mol) | p-Maleinimidylphenol |
| 1264,8 g (11,08 Mol) | Allylglycidylether |
| 4,95 g ( 0,030 Mol) | $\alpha,\alpha'$-Azobisisobutyronitril (AIBN). |

Nach dem Inertisieren mit Stickstoff wird die Suspension unter Rühren mit einem Oelbad aufgeheizt. Bei ca. 70 °C Innentemperatur setzt die Polymerisation unter erheblicher Wärmetönung ein. Das Oelbad wird entfernt und mit einem Eisbad für ca. 10 Min. gekühlt. Mit dem Oelbad heizt man dann während 7 Stunden bei einer Temperatur von ca. 70 °C. Die gelbliche Suspension wird unter gutem Rühren in 4000 ml Toluol eingetragen, die Ausfällung abfiltriert und im Vakuum während 14 Stunden bei 60 °C getrocknet. Man löst das Festprodukt in Aceton und fällt nochmals aus Toluol. Nach dem Trocknen im Vakuum verbleiben 427,9 g farbloses, festes Copolymer.

Elementaranalyse:

gefunden %: C 63,52 H 5,88 N 3,94
Zusammensetzung berechnet nach N-Gehalt: 2,83 Mol/kg Maleinimidylphenol

$\bar{M}_w$ = 7664
$\bar{M}_n$ = 4265 } GPC[1] (Polystyrol Standards)

[1] Gelpermeationschromatographie

Epoxidwert (titrimetrisch): 2,77 Val/kg

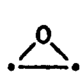

### Beispiel 2:

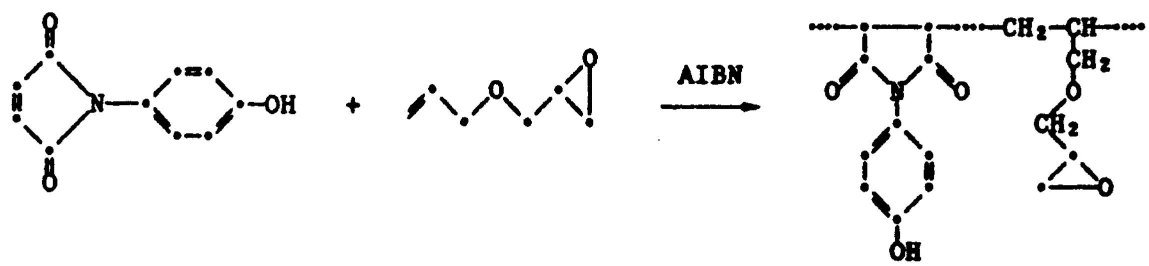


Einen 350 ml Sulfierkolben, ausgestattet wie in Beispiel 1, beschickt man mit:

| | |
|---|---|
| 18,92 g ( 0,100 Mol) | p-Maleinimidylphenol |
| 11,42 g ( 0,100 Mol) | Allylglycidylether |
| 144,50 g | Methylethylketon |
| 0,380 g ( 0,0023 Mol) | $\alpha,\alpha'$-Azobisisobutyronitril (AIBN) |

Man inertisiert mit Stickstoff und polymerisiert während 7 Stunden bei ca. 70 °C, wie im Beispiel 1 beschrieben. Die gelbliche, klare Lösung wird unter gutem Rühren in Toluol eingetropft, der Niederschlag abfiltriert und im Vakuum bei 60 °C getrocknet. Nach nochmaligem Umfällen der Acetonlösung in Toluol verbleiben nach dem Trocknen 19,86 g festes Copolymer als Pulver.

Elementaranalyse:

gefunden %: C 60,33 H 4,90 N 6,07
Zusammensetzung berechnet nach N-Gehalt: 4,31 Mol/kg Maleinimidylphenol

$$\left.\begin{array}{l}\bar{M}_w = 5670\\ \bar{M}_n = 3217\end{array}\right\}\ \text{GPC (Polystyrol Standards)}$$

Beispiel 3:

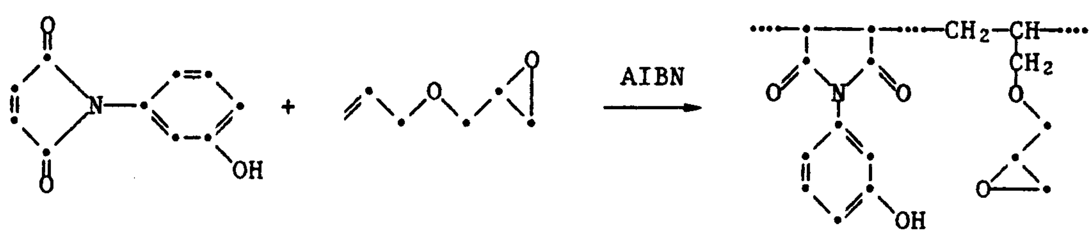


Analog dem Verfahren von Beispiel 1 polymerisiert man:

| | |
|---|---|
| 9,45 g (0,050 Mol) | m-Maleinimidylphenol |
| 51,15 g (0,488 Mol) | Allylglycidylether |
| 0,20 g (0,0012 Mol) | $\alpha,\alpha'$-Azobisisobutyronitril (AIBN) |

Nach dem Umfällen mit Toluol verbleiben 14,88 g farbloses, festes Copolymer.

Elementaranalyse:

gefunden %: C 62,63 H 5,83 N 4,27
Zusammensetzung (berechnet nach N-Gehalt): 3,07 Mol/kg Maleinimidylphenol

$\bar{M}_w = 7732$
$\bar{M}_n = 4607$
} GPC (Polystyrol Standards)

Epoxidwert (titrimetrisch): 3,06 Val/kg

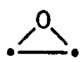

Beispiel 4:

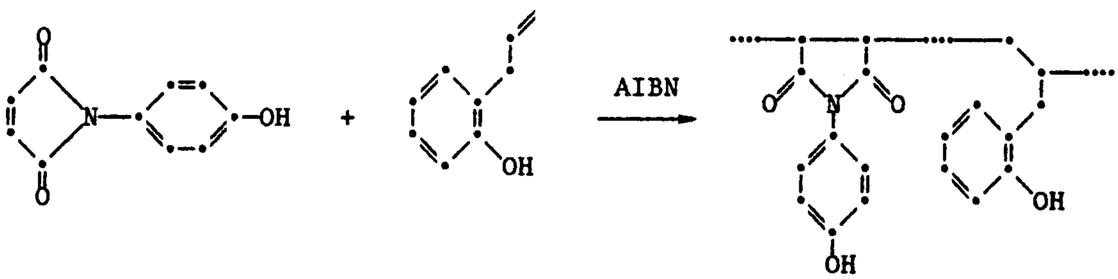


Eine Apparatur bestehend aus 100 ml Dreihalsrundkolben, Magnetrührer, Oelbad, Thermometer, Kühler sowie Gaseinleitungsrohr und Blasenzähler beschickt man mit:

| | |
|---|---|
| 9,45 g ( 50 mMol) | p-Maleinimidylphenol |
| 40,25 g (300 mMol) | 2-Allylphenol |
| 0,28 g ( 1,7 mMol) | $\alpha,\alpha'$-Azobisisobutyronitril (AIBN) |

In einem schwachen Stickstoffstrom rührt man das Reaktionsgemisch während 24 Stunden bei ca. 65 °C. Danach wird die gelbliche Suspension unter Rühren langsam in 300 ml Ether eingetragen, der Niederschlag abfiltriert und mit ca. 200 ml Ether gewaschen. Nach dem Trocknen verbleiben 12,3 g farbloses Pulver.

Elementaranalyse:

gefunden %: C 68,12 H 5,86 N 4,40
Zusammensetzung berechnet nach N-Gehalt: 3,15 Mol/kg Maleinimidylphenol
Gehalt an phenolischem OH: 5,56 Mol/kg

$\bar{M}_w = 4154$
$\bar{M}_n = 3004$
} GPC (Polystyrol Standards)

Beispiel 5:

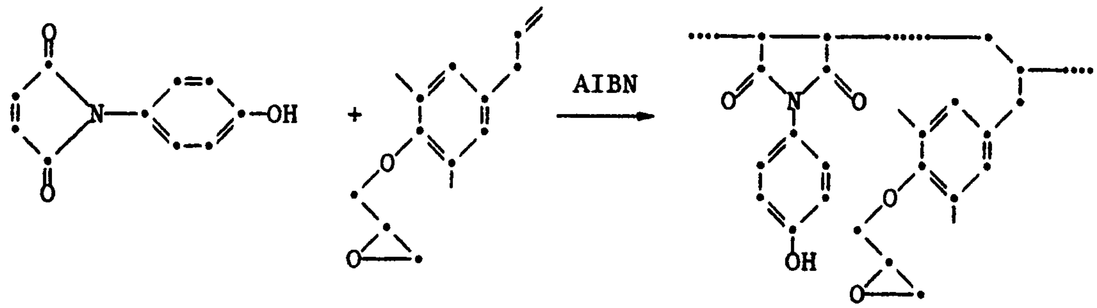


Eine Apparatur bestehend aus: 1 l Dreihalsrundkolben, Magnetrührer, Oelbad, Thermometer, Kühler sowie Gaseinleitungsrohr und Blasenzähler beschickt man mit:

| | |
|---|---|
| 18,92 g (100 mMol) | p-Maleinimidylphenol |
| 65,49 g (300 mMol) | 2,6-Dimethyl-4-allyl-phenylglycidylether |
| 0,38 g ( 2,3 mMol) | α,α′-Azobisisobutyronitril (AIBN) |
| 420 ml | Tetrahydrofuran |

In einem schwachen Stickstoffstrom rührt man das Reaktionsgemisch während 24 Stunden bei ca. 65 °C. Danach wird die gelbliche Suspension unter Rühren langsam in 1 l Ether eingetragen, der Niederschlag abfiltriert und mit ca. 200 ml Ether gewaschen. Nach dem Trocknen verbleiben 17,0 g farbloses Pulver.

<u>Elementaranalyse:</u>

gefunden %: C 66,83 H 5,78 N 4,65
Zusammensetzung berechnet nach N-Gehalt: 4,14 Mol/kg Maleinimidylphenol

$$\left.\begin{array}{l}\bar{M}_w = 3503 \\ \bar{M}_n = 2342\end{array}\right\} \text{GPC (Polystyrol Standards)}$$

<u>Beispiel 6:</u>

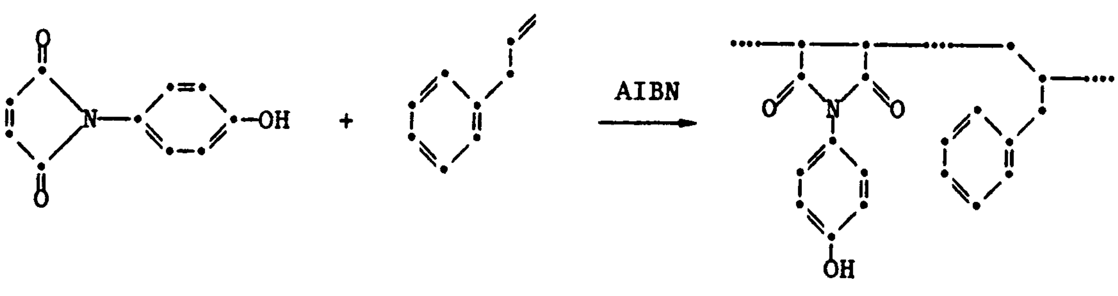


Analog dem Verfahren von Beispiel 4 polymerisiert man:

| | |
|---|---|
| 18,92 g (100 mMol) | p-Maleinimidylphenol |
| 90,00 g (762 mMol) | Allylbenzol |
| 0,39 g ( 2,4 mMol) | α,α′-Azobisisobutyronitril (AIBN) |

Nach dem Eintragen in Ether, Filtrieren, Waschen mit Ether und Trocknen verbleiben 20,8 g farbloses Pulver.

<u>Elementaranalyse:</u>

gefunden %: C 71,15 H 5,72 N 5,12
Zusammensetzung berechnet nach N-Gehalt: 3,65 Mol/kg Maleinimidylphenol

$$\left.\begin{array}{l}\bar{M}_w = 4650 \\ \bar{M}_n = 2746\end{array}\right\} \text{GPC (Polystyrol Standards)}$$

Beispiel 7:

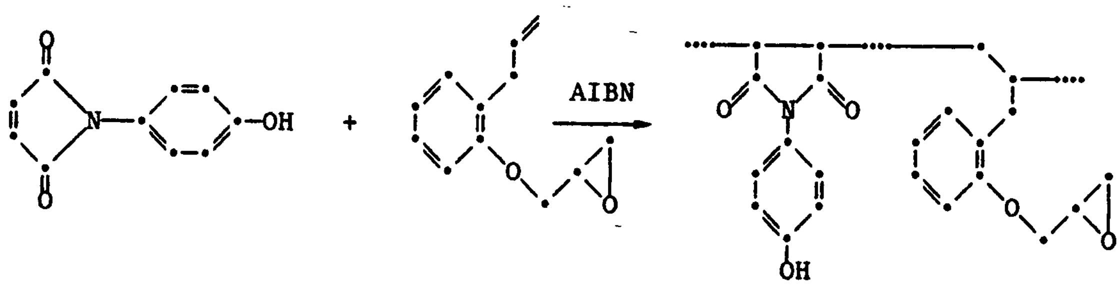


Analog dem Verfahren von Beispiel 5 polymerisiert man:

| | |
|---|---|
| 18,92 g (100 mMol) | p-Maleinimidylphenol |
| 95,12 (500 mMol) | 2-Allyl-phenylglycidylether |
| 0,38 g ( 2,3 mMol) | α,α'-Azobisisobutyronitril (AIBN) |
| 400 ml | Tetrahydrofuran |

Nach dem Eintragen in Ether, Filtrieren, Waschen mit Ether und Trocknen verbleiben 17,2 g farbloses Pulver.

Elementaranalyse:

gefunden %: C 67,16 H 5,49 N 4,66
Zusammensetzung berechnet nach N-Gehalt: 3,33 Mol/kg Maleinimidylphenol

$$\left.\begin{array}{l}\bar{M}_w = 2614 \\ \bar{M}_n = 1680\end{array}\right\} \text{GPC (Polystyrol Standards)}$$

Beispiel 8:

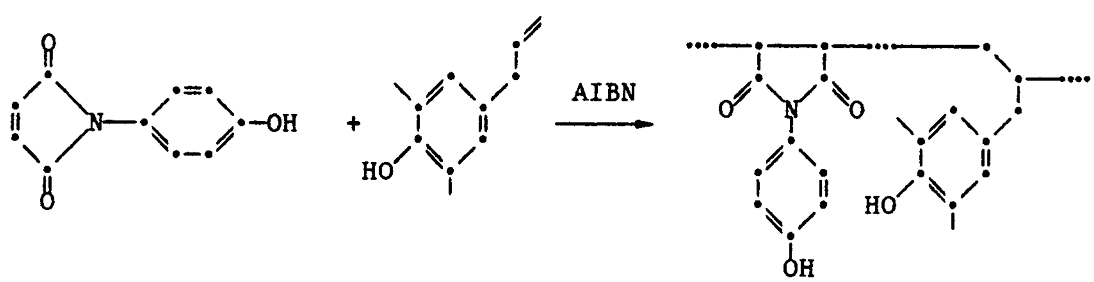


Analog dem Verfahren von Beispiel 5 polymerisiert man:

| | |
|---|---|
| 19,40 g (102,6 mMol) | p-Maleinimidylphenol |
| 100,00 g (616 mMol) | 4-Allyl-2,6-dimethylphenol |
| 0,39 g ( 2,4 mMol) | α,α'-Azobisisobutyronitril (AIBN) |
| 400 ml | Tetrahydrofuran |

Nach dem Eintragen in Ether, Filtrieren, Waschen mit Ether und Trocknen verbleiben 27.3 g farbloses Pulver.

Elementaranalyse:

gefunden (%): C 68,08 H 5,77 N 4,92
Zusammensetzung berechnet nach N-Gehalt: 3,53 Mol/kg Maleinimidylphenol

$$\left.\begin{array}{l}\bar{M}_w = 2578 \\ \bar{M}_n = 1817\end{array}\right\} \text{GPC (Polystyrol Standards)}$$

Beispiel 9:

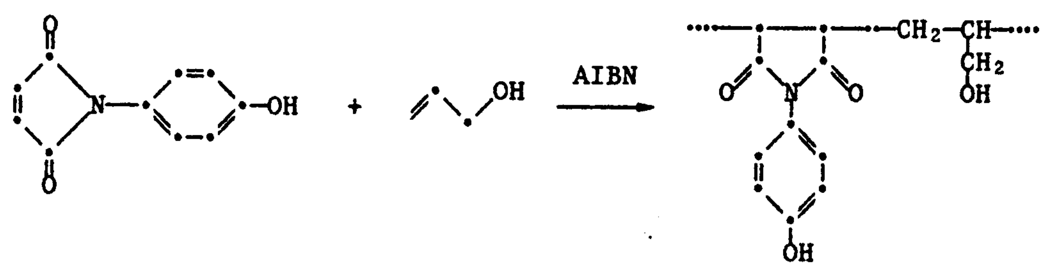


Analog dem Verfahren von Beispiel 1 polymerisiert man

| | |
|---|---|
| 189,17 g (1,0 Mol) | p-Maleinimidylphenol |
| 232,32 g (4,0 Mol) | Allylalkohol |
| 600 g | 1-Methoxypropanol (Dowanol®PM) |
| 3,83 g | α,α'-Azobisisobutyronitril (AIBN) |

während 24 h bei 70°C. Nach dem Fällen (Diethylether) und Trocknen (Vakuum, 80°C, 8 h) erhält man 248,8 g festes Copolymer.

Elementaranalyse:

gefunden (%): C 61,20 H 5,87 N 5,44
Zusammensetzung (aus N-Gehalt):

| | |
|---|---|
| 3,88 Mol/kg | Maleinimidylphenol |
| 4,57 Mol/kg | Allylalkohol |

$$\left.\begin{array}{l}\bar{M}_w = 2979 \\ \bar{M}_n = 1826\end{array}\right\} \text{GPC (Polystyrol Standards)}$$

Beispiel 10:

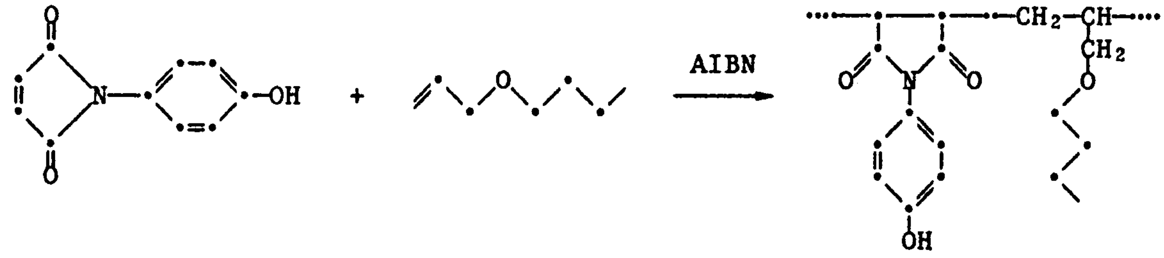


Analog dem Verfahren von Beispiel 1 polymerisiert man

9,45 g (0,05 Mol) p-Maleinimidylphenol
22,84 g (0,20 Mol) Allylbutylether
30,0 g 1-Methoxypropanol (Dowanol®PM)
0,235 g α,α'-Azobisisobutyronitril (AIBN)

während 24 h bei 70 °C. Nach dem Fällen (Diethylether) und Trocknen (Vakuum, 100 °C, 6 h) erhält man 11,6 g festes Copolymer.

Elementaranalyse:

gefunden (%): C 63,91 H 6,18 N 5,38
Zusammensetzung (aus N-Gehalt):
3,84 Mol/kg Maleinimidylphenol
2,39 Mol/kg Allylbutylether

$$\left.\begin{array}{l}\bar{M}_w = 5744 \\ \bar{M}_n = 3434\end{array}\right\}\ \text{GPC (Polystyrol Standards)}$$

Beispiel 11:

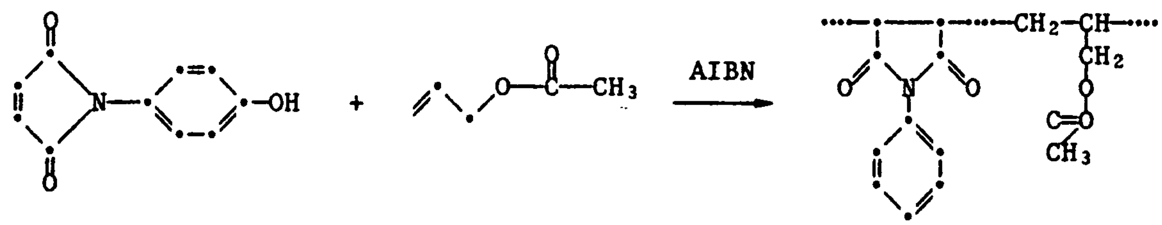


Analog dem Verfahren von Beispiel 1 polymerisiert man

9,45 g (0,05 Mol) p-Maleinimidylphenol
20,02 g (0,20 Mol) Essigsäure-allylester
30,0 g 1-Methoxypropanol (Dowanol®PM)
0,22 g α,α'-Azobisisobutyronitril (AIBN)

während 24 h bei 70 °C. Nach dem Fällen 1000 ml Diethylether und Trocknen bei 100 °C im Vakuum (6 h) verbleiben 12,3 g farbloses, festes Copolymer.

Elementaranalyse:

gefunden (%): C 61,11 H 5,47 N 5,43
Zusammensetzung berechnet aus N-Gehalt:
3,88 Mol/kg Maleinimidylphenol
2,66 Mol/kg Essigsäure-allylester

$\bar{M}_w = 5109$ } GPC (Polystyrol Standards)
$\bar{M}_n = 2978$

Anwendungsbeispiele

Beispiel A

Dieses Beispiel zeigt die Anwendung als Bindemittel für die Formulierung von wässrig-alkalisch entwickelbaren Negativ-Photoresists auf Epoxidharz-Basis.

Beschichtungslösung

Polymer aus Beispiel 1 1,80 g
3,4-Epoxicyclohexylmethyl-3,4-epoxicyclohexancarboxylat 1,20 g
Photoinitiator (Stilben-cyclopentadienyl-eisen-(II)-hexafluorphosphat als 10 %ige Lösung in Cyclohexanon) 1,50 g
Orasolrot B Farbstoff 0,006 g
Methylethylketon/Methylcellosolve 5,50 g

Unter Gelblicht beschichtet man die Lösung mittels eines Ziehrakels in ca. 100 µm Nassfilmdicke auf eine gereinigte, kupferkaschierte Leiterplatte. Man trocknet während 30 Min bei 80 °C und erhält eine Trockenschichtdicke von ca. 25 g/m². Diese Photoresist-beschichtete Leiterplatte wird durch eine Photomaske (Stouffer Sensitivity Guide) mittels einer 5000 W Halogenlampe (Silvania M 061) im Abstand von 65 cm wie üblich belichtet und dann thermisch nachbehandelt. Als Entwickler dient folgende Lösung:

| | |
|---|---|
| 75,00 g | Natrium-metasilicat pentahydrat |
| 0,40 g | Suprionic® B 50 (ABM Chemicals Ltd, Stockport Cheshire GB); Netzmittel |
| 1925,00 g | Deionisiertes Wasser. |

Resultat

| | |
|---|---|
| Belichtungszeit: | 15 sec |
| Thermische Behandlung: | 10 Min/120 °C |
| Entwicklungszeit: | 30 sec/20 °C (Manuell mit Baumwolltuch) |
| Keilkopie: | Letzte abgebildete Stufe = Nr.9 |

**Patentansprüche**

**1.** Copolymere enthaltend 30-100 Mol%, bezogen auf das Gesamtpolymere, an Struktureinheiten der Formeln I und II, wobei der Anteil der Reste der Formel I, bezogen auf den gesamten Anteil von I und II, 5 bis 95 Mol% ausmacht

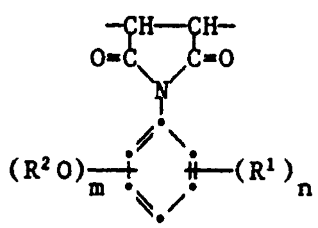 (I), 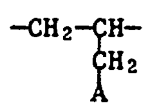 (II),

worin $R^1$ $C_1$-$C_4$Alkyl, $C_1$-$C_4$Alkoxy oder Halogen ist,
$R^2$ Wasserstoff oder -$COR^3$ bedeutet und $R^3$ $C_1$-$C_{20}$Alkyl ist,
m 1, 2 oder 3 darstellt, n 0, 1, 2, 3 oder 4 ist und die Summe von m und n höchstens 5 bedeutet, A ausgewählt wird aus der Gruppe der Reste bestehend aus Halogen, Cyano oder Struktureinheiten der Formeln III bis VIII

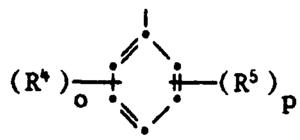 (III), 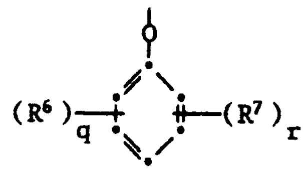 (IV),

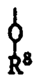 (V), 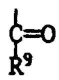 (VI), 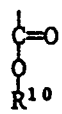 (VII), 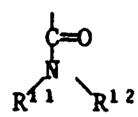 (VIII),

worin $R^4$ und $R^6$ unabhängig voneinander Hydroxy,

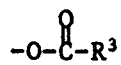

oder Glycidylgruppen der Formel IXa oder IXb darstellen

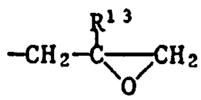 (IXa), 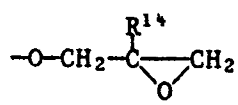 (IXb),

$R^5$ und $R^7$ unabhängig voneinander $C_1$-$C_4$Alkyl, $C_1$-$C_4$Alkoxy oder Halogen sind,
o und q unabhängig voneinander 0, 1, 2 oder 3 sind,
p und r unabhängig voneinander 0, 1, 2, 3, 4 oder 5 bedeuten,
wobei die Summen o + p und q + r höchstens 5 betragen dürfen,
$R^8$ Wasserstoff, $C_1$-$C_{20}$Alkyl, ein Glycidylrest der Formel IXa oder ein Rest der Formel VI ist,
$R^9$ Wasserstoff, $C_1$-$C_{20}$Alkyl, Cycloalkyl mit 5-7 Ring C-Atomen, Phenyl, Naphthyl oder Benzyl darstellt,
$R^{10}$ Wasserstoff, $C_1$-$C_{20}$Alkyl oder ein Glycidylrest der Formel IXa ist und die Gruppen $R^{11}$ und $R^{12}$ unabhängig voneinander Wasserstoff, $C_1$-$C_{20}$Alkyl, Cycloalkyl mit 5-7 Ring C-Atomen, gegebenenfalls substituiertes Aryl oder Aralkyl oder ein Glycidylrest der Formel IXa sind oder zusammen mit dem gemeinsamen Stickstoffatom einen fünf- oder sechsgliedrigen nichtaromatischen heterocyclischen Ring bilden und $R^{13}$ und $R^{14}$ unabhängig voneinander Wasserstoff oder Methyl sind, wobei die Reste $R^1$ bis $R^{14}$ und A eines Polymermoleküls innerhalb der gegebenen Definitionen unterschiedlich sein können;
und 70-0 mol%, bezogen auf das Gesamtpolymere, an Struktureinheiten, die sich von radikalisch polymerisierbaren Vinylverbindungen ableiten.

2. Copolymere gemäss Anspruch 1, worin der Anteil der Struktureinheiten I und 11 50-100 Mol%, bezogen auf das Gesamtpolymere, ausmacht.

3. Copolymere gemäss Anspruch I bestehend ausschliesslich aus Strukturelementen der Formeln I und II.

4. Copolymere gemäss Anspruch 1, worin der Anteil der Reste der Formel I, bezogen auf den Anteil von I und II, 10-80 Mol% ausmacht.

5. Copolymere gemäss Anspruch 1, worin $R^2$ Wasserstoff bedeutet.

6. Copolymere gemäss Anspruch 5, worin A ausgewählt wird aus der Gruppe der Reste der Formeln III, IV, V, VII und VIII, $R^4$ und $R^6$ Glycidylgruppen der Formeln IXa oder IXb darstellen, $R^8$, $R^{10}$ und mindestens einer der Reste $R^{11}$ oder $R^{12}$ eine Glycidylgruppe der Formel IXa ist und o und q unabhängig voneinander 1, 2 oder 3 sind.

7. Copolymere gemäss Anspruch 5, worin A ein Rest der Formel V ist und $R^8$ eine Gruppe der Formel

IXa bedeutet.

8. Copolymere gemäss Anspruch 5, worin A ein Gruppe der Formeln III oder IV ist, $R^4$ und $R^6$ Glycidylgruppen der Formel IXb sind, o und q 1 oder 2 bedeuten und p und r 0 sind.

9. Copolymere gemäss Anspruch 5, worin m 1 ist, n 0, 1 oder 2 bedeutet, A ausgewählt wird aus der Gruppe bestehend aus den Resten der Formel III, IV oder V und $R^8$ $C_1$-$C_4$Alkyl oder ein Rest der Formel VI ist, worin $R^9$ $C_1$-$C_4$Alkyl bedeutet.

10. Verfahren zur Herstellung von Copolymeren gemäss Anspruch 1 dadurch gekennzeichnet, dass man
a) 30-100 mol% Verbindungen der Formel Ia und IIa

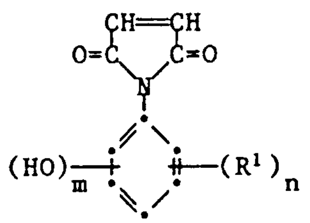
(Ia),
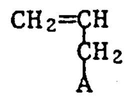
(IIa),

worin $R^1$, A, m und n die in Anspruch 1 definierte Bedeutung besitzen, gegebenenfalls in Anwesenheit von 70-0 mol% weiterer radikalisch polymerisierbarer Vinylverbindungen radikalisch polymerisiert und das Produkt gegebenenfalls mit einem zur Einführung des Restes $R^3$-CO- befähigten Reagenz weiter umsetzt oder dass man
b) 30-100 mol% Verbindungen der Formel Ib und IIa

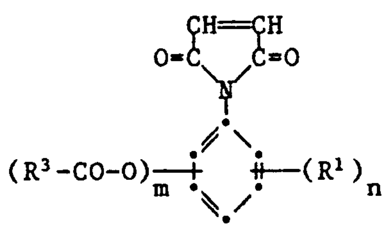
(Ib),
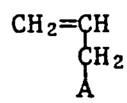
(IIa),

worin $R^1$, $R^3$, A, m und n die in Anspruch 1 definierte Bedeutung besitzen, gegebenenfalls in Anwesenheit von 70-0 mol% radikalisch polymerisierbarer Vinylverbindungen radikalisch polymerisiert und das Produkt gegebenenfalls durch (teilweise) Hydrolyse der $R^3$-CO- Gruppe in ein anderes Copolymeres gemäss Anspruch 1 überführt.

11. Verwendung der Copolymeren gemäss Anspruch 5 als Bindemittel für Photoresists oder als Epoxidhärter.

12. Verwendung der Copolymeren gemäss Anspruch 6 als selbstvernetzende Epoxidharze.

## Claims

1. A copolymer containing 30-100 mol%, relative to the total polymer, of structural units of the formulae I and II, the proportion of radicals of the formula I, relative to the total proportion of I and II, being 5 to 95 mol%,

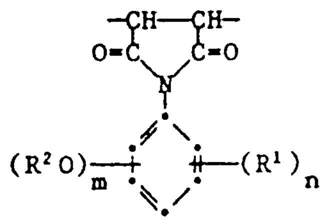 (I), 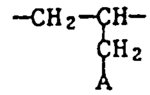 (II),

in which R' is $C_1$-$C_4$alkyl, $C_1$-$C_4$alkoxy or halogen, $R^2$ is hydrogen or $-COR^3$ and $R^3$ is $C_1$-$C_{20}$alkyl, m is 1, 2 or 3, n is 0, 1, 2, 3 or 4 and the sum of m and n is not more than 5, and A is selected from the group of radicals consisting of halogen, cyano or structural units of the formulae III to VIII

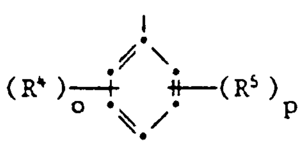 (III), 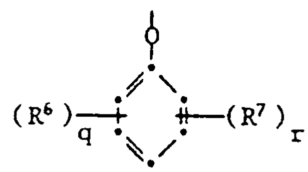 (IV),

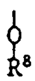 (V), 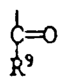 (VI), 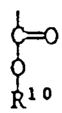 (VII), 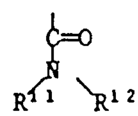 (VIII),

in which $R^4$ and $R^6$ independently of one another are hydroxyl,

$$-O-\overset{\overset{O}{\|}}{C}-R^3$$

or glycidyl groups of the formula IXa or IXb

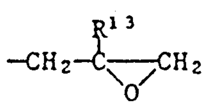 (IXa), 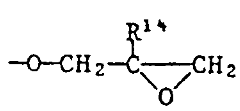 (IXb),

$R^5$ and $R^7$ independently of one another are $C_1$-$C_4$alkyl, $C_1$-$C_4$alkoxy or halogen, o and q independently of one another are 0, 1, 2 or 3, p and r independently of one another are 0,1,2,3, 4 or 5, it being necessary for the total o+p and q+r to be not more than 5, $R^8$ is hydrogen, $C_1$-$C_{20}$alkyl, a glycidyl radical of the formula IXa or a radical of the formula VI, $R^9$ is hydrogen, $C_1$-$C_{20}$alkyl, cycloalkyl having 5-7 ring C atoms, phenyl, naphthyl or benzyl, $R^{10}$ is hydrogen, $C_1$-$C_{20}$alkyl or a glycidyl radical of the formula IXa, and the groups $R^{11}$ and $R^{12}$ independently of one another are hydrogen, $C_1$-$C_{20}$alkyl, cycloalkyl having 5-7 ring C atoms, aryl or aralkyl which is substituted or unsubstituted or a glycidyl radical of the formula IXa, or, together with the common nitrogen atom, form a five-membered or six-membered, non-aromatic, heterocyclic ring, and $R^{13}$ and $R^{14}$ independently of one another are hydrogen or methyl, it being possible for the radicals $R^1$ to $R^{14}$ and A of a polymer molecule to be different and 70-0 mol%, relative to the total polymer, of structural units derived from vinyl compounds which can be polymerized by free radicals.

**2.** A copolymer according to claim 1, in which the proportion of the structural units I and II is 50-100 mol%, relative to the total polymer.

**3.** A copolymer according to claim 1, consisting solely of structural elements of the formulae I and II.

**4.** A copolymer according to claim 1, in which the proportion of radicals of the formula I, relative to the proportion of I and II, is 10-80 mol%.

**5.** A copolymer according to claim 1, in which $R^2$ is hydrogen.

**6.** A copolymer according to claim 5, in which A is selected from the group comprising radicals of the formulae III, IV, V, VII and VIII, $R^4$ and $R^6$ are glycidyl groups of the formulae IXa or IXb, $R^8$, $R^{10}$ and at least one of the radicals $R^{11}$ or $R^{12}$ are a glycidyl group of the formula IXa and o and q independently of one another are 1, 2 or 3.

**7.** A copolymer according to claim 5, in which A is a radical of the formula V and $R^8$ is a group of the formula IXa.

**8.** A copolymer according to claim 5, in which A is a group of the formulae III or IV, $R^4$ and $R^6$ are glycidyl groups of the formula IXb, o and q are 1 or 2 and p and r are 0.

**9.** A copolymer according to claim 5, in which m is 1, n is 0, 1 or 2, A is selected from the group consisting of the radicals of the formula III, IV and V and $R^8$ is $C_1$-$C_4$alkyl or a radical of the formula VI in which $R^9$ is $C_1$-$C_4$alkyl.

**10.** A process for the preparation of copolymers according to claim 1, which comprises

a) subjecting to free-radical polymerization 30-100 mol% of compounds of the formula Ia and IIa

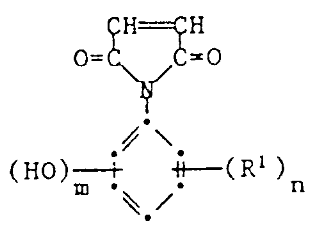 (Ia), 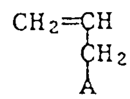 (IIa),

in which $R^1$, A, m and n are as defined in claim 1, if appropriate in the presence of 70-0 mol% of further vinyl compounds which can be polymerized by free radicals, and, if desired, reacting the product further with a reagent capable of introducing the radical $R^3$-CO-, or

b) subjecting to free-radical polymerization 30-100 mol% of compounds of the formula Ib and IIa

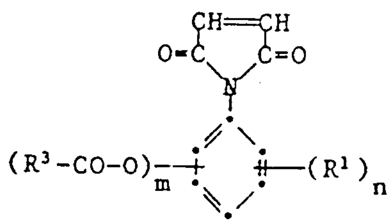 (Ib), 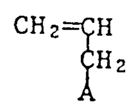 (IIa),

in which $R^1$, $R^3$, A, m and n are as already defined in claim 1, if appropriate in the presence of 70-0 mol% of further vinyl compounds which can be polymerized by free radicals, and, if desired, converting the product by (partial) hydrolysis of the $R^3$-CO- group into another copolymer according to claim 1.

**11.** The use of the copolymers according to claim 5 as binders for photoresists or as epoxide curing agents.

**12.** The use of the copolymers according to claim 6 as self-crosslinking epoxide resins.

## Revendications

**1.** Copolymères renfermant de 30 à 100 % en moles, par rapport au polymère total, d'unités structurales de formules I et II, la proportion des unités structurales de formule I par rapport à l'ensemble des unités I et II représentant de 5 à 95 % en moles,

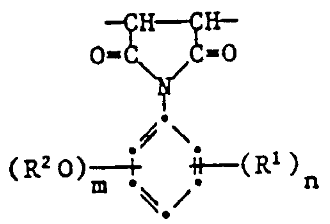 (I), 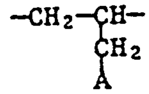 (II),

formules dans lesquelles

| | |
|---|---|
| $R^1$ | représente un alkyle en $C_1$-$C_4$, un alcoxy en $C_1$-$C_4$ ou un halogène, |
| $R^2$ | représente l'hydrogène ou un radical $-COR^3$ dont le symbole $R^3$ représente un alkyle en $C_1$-$C_{20}$, |
| m | est égal à 1, à 2 ou à 3, |
| n | est égal à 0, à 1, à 2, à 3 ou à 4, la somme (m + n) étant au plus égale à 5, et |
| A | représente un radical pris dans l'ensemble constitué par les halogènes, le cyano et les unités structurales répondant aux formules III à VIII : |

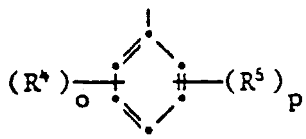 (III), 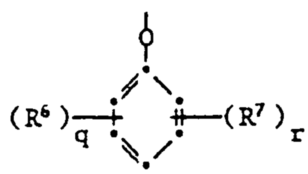 (IV),

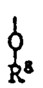 (V), 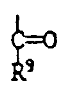 (VI), 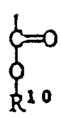 (VII), 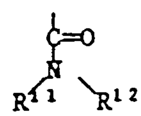 (VIII),

$R^4$ et $R^6$ représentent chacun, indépendamment l'un de l'autre, un hydroxy, un radical

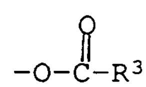

ou un radical glycidyle de formule IXa ou IXb :

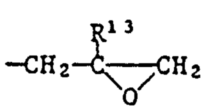 (IXa), 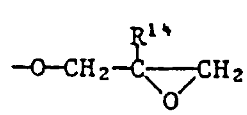 (IXb),

| | |
|---|---|
| $R^5$ et $R^7$ | représentent chacun, indépendamment l'un de l'autre, un alkyle en $C_1$-$C_4$, un alcoxy en $C_1$-$C_4$ ou un halogène, |
| o et q | représentent chacun, indépendamment l'un de l'autre, un nombre égal à 0, à 1, à 2 ou à 3, |
| p et r | représentent chacun, indépendamment l'un de l'autre, un nombre égal à 0, à 1, à 2, à 3, à 4 ou à 5, la somme (o + p) et la somme (q + r) étant chacune au plus égale à 5, |
| $R^8$ | représente l'hydrogène, un alkyle en $C_1$-$C_{20}$, un glycidyle de formule IXa ou un |

radical de formule VI,

$R^9$ représente l'hydrogène, un alkyle en $C_1$-$C_{20}$, un cycloalkyle contenant de 5 à 7 atomes de carbone dans son cycle, un phényle, un naphtyle ou un benzyle,

$R^{10}$ représente l'hydrogène, un alkyle en $C_1$-$C_{20}$ ou un glycidyle de formule IXa,

$R^{11}$ et $R^{12}$ représentent chacun, indépendamment l'un de l'autre, l'hydrogène, un alkyle en $C_1$-$C_{20}$, un cycloalkyle contenant de 5 à 7 atomes de carbone dans son cycle, un radical aryle ou aralkyle éventuellement substitué ou un glycidyle de formule IXa, ou forment ensemble, avec l'atome d'azote commun, un hétérocycle non aromatique à 5 ou 6 maillons, et

$R^{13}$ et $R^{14}$ représentent chacun, indépendamment l'un de l'autre, l'hydrogène ou un méthyle, les radicaux $R^1$ à $R^{14}$ et A dans une même molécule de polymère pouvant avoir des significations différentes à l'intérieur des définitions données,

et de 70 à 0 % en moles, par rapport au polymère total, d'unités structurales dérivant de composés vinyliques polymérisables par voie radicalaire.

2. Copolymères selon la revendication 1 dans lesquels la proportion des unités structurales I et II est de 50 à 100 % en moles par rapport au polymère total.

3. Copolymères selon la revendication 1 qui sont constitués exclusivement d'unités structurales de formules I et II.

4. Copolymères selon la revendication 1 dans lesquels la proportion des radicaux de formule I, par rapport à l'ensemble des radicaux I et IL, est comprise entre 10 et 80 % en moles.

5. Copolymères selon la revendication 1 dans lesquels $R^2$ représente l'hydrogène.

6. Copolymères selon la revendication 5 dans lesquels A est choisi dans l'ensemble constitué par les radicaux de formules III, IV, V, VII et VIII, $R^4$ et $R^6$ représentent chacun un radical glycidyle de formule IXa ou IXb, $R^8$, $R^{10}$ et au moins un des symboles $R^{11}$ et $R^{12}$ représentent un radical glycidyle de formule IXa, et o et q représentent chacun, indépendamment l'un de l'autre, un nombre égal à 1, à 2 ou à 3.

7. Copolymères selon la revendication 5 dans lesquels A représente un radical de formule V et $R^8$ un radical de formule IXa.

8. Copolymères selon la revendication 5 dans lesquels A représente un radical de formule III ou IV, $R^4$ et $R^6$ représentent chacun un radical glycidyle de formule IXb, o et q sont égaux chacun à 1 ou à 2, et p et r sont égaux chacun à 0.

9. Copolymères selon la revendication 5 dans lesquels m est égal à 1, n est égal à 0, à 1 ou à 2, A est choisi dans l'ensemble constitué par les radicaux de formules III, IV et V, et $R^8$ représente un alkyle en $C_1$-$C_4$ ou un radical de formule VI dans lequel $R^9$ représente un alkyle en $C_1$-$C_4$.

10. Procédé pour préparer des copolymères selon la revendication 1, procédé caractérisé en ce que :
a) on polymérise par voie radicalaire de 30 à 100 % en moles de composés répondant aux formules Ia et IIa :

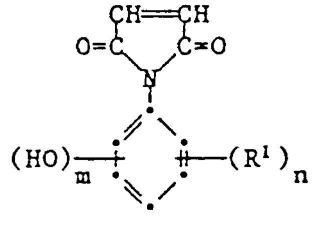 (Ia), 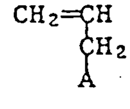 (IIa),

dans lesquelles $R^1$, A, m et n ont les significations indiquées à la revendication 1, éventuellement en présence de 70 à 0 % en moles d'autres composés vinyliques polymérisables par voie radicalaire,

et, le cas échéant, on fait éventuellement réagir ultérieurement le produit avec un réactif capable d'introduire le radical $R^3$-CO-,
ou en ce que :
b) on polymérise par voie radicalaire de 30 à 100 % en moles de composés répondant aux formules Ib et IIa :

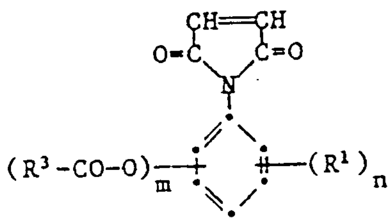 (Ib), 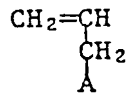 (IIa),

dans lesquelles $R^1$, $R^3$, A, m et n ont les significations indiquées à la revendication 1, éventuellement en présence de 70 à 0 % en moles d'autres composés vinyliques polymérisables par voie radicalaire, et on transforme éventuellement le produit, par hydrolyse (partielle) du radical $R^3$-CO-, en un autre copolymère selon la revendication 1.

**11.** Application des copolymères selon la revendication 5 comme liants pour des photorésists ou comme durcisseurs d'époxydes.

**12.** Application des copolymères selon la revendication 6 comme résines époxydiques auto-réticulantes.